# EUROPÄISCHE PATENTANMELDUNG

(11) **EP 0 837 305 A1**
(43) Veröffentlichungstag der Anmeldung: **22.04.1998**
(21) Anmeldenummer: 97810728.2
(22) Anmeldetag: 02.10.1997
(51) Int. Cl.: G01J 5/00, H05H 1/00, C23C 4/12

(54) **Einrichtung sowie Verfahren zur Überwachung des Beschichtungsprozesses einer thermischen Beschichtungsvorrichtung**

(30) Priorität: 21.10.1996 CH 2561/96
(71) Anmelder: Sulzer Metco AG, 5610 Wohlen (CH)
(72) Erfinder: Schütz, Matthias, CH-8052 Zürich (CH)
(74) Vertreter: Rottmann, Maximilian R.

(57) **Zusammenfassung**

Um während eines Beschichtungsprozesses eine Aussage über die zu erwartende Qualität der durch die thermische Beschichtungsvorrichtung (17) auf ein Substrat aufgetragenen Schicht machen zu können, wird eine Einrichtung vorgeschlagen, die eine Vielzahl von Sensoren (3a) aufweist und/oder mit optischen Mitteln versehen ist, um die Strahlung in einem Abschnitt des Beschichtungsstrahls (19), in seiner Querausdehnung messtechnisch in einzelne Bereiche aufgeteilt, zu erfassen. Zur Auswertung der gemessenen Signale sind der Sensoranordnung elektronische Mittel nachgeschaltet. Eine derartige Einrichtung ermöglicht den Beschichtungsstrahl systematisch zu überwachen. Aufgrund der an der Sensoranordnung (3) anliegenden Signale kann die räumliche Intensitätsverteilung der von den erhitzten Partikeln (20) emittierten Strahlung ermittelt und als relevante Grösse zur qualitativen Beurteilung und/oder Beeinflussung der zu erwartenden Schichtqualität herangezogen werden.

## Beschreibung

Die Erfindung betrifft eine Einrichtung zur Überwachung des Beschichtungsprozesses einer thermischen Beschichtungsvorrichtung gemäss dem Oberbegriff des Anspruchs 1. Im weiteren wird im Anspruch 17 ein Verfahren zur Überwachung des Beschichtungsprozesses einer thermischen Beschichtungsvorrichtung mit einer Einrichtung gemäss Anspruch 1 unter Schutz gestellt.

Um während des Beschichtungsprozesses eine Aussage über die zu erwartende Qualität der durch die Beschichtungsvorrichtung auf ein Substrat aufgetragenen Schicht machen zu können, hat sich als bisher zuverlässigste Methode die Erfassung der Temperatur und der Geschwindigkeit der im Beschichtungsstrahl mitgeführten, erhitzten Partikel erwiesen.

Ein Verfahren sowie eine Vorrichtung zum Messen der Temperatur und der Geschwindigkeit der im Beschichtungsstrahl eines Plas- maspritzgerätes mitgeführten Partikel ist aus der US-PS Nr. 5 180 921 bekannt. Diese Vorrichtung weist einen Sensorkopf auf, der über eine optische Faser mit einer Auswerteeinheit verbunden ist, mittels welcher im wesentlichen punktuell sowohl die Partikeltemperatur wie auch die Partikelgeschwindigkeit im Plasmastrahl ermittelt werden können. Zur Bestimmung der Partikelgeschwindigkeit ist die optische Faser endseitig mit einer Lochmaske versehen, in die zwei Schlitze eingelassen sind. Mittels diesen zwei in einem definierten Abstand voneinander angeordneten Schlitzen kann die Zeit gemessen werden, die ein Partikel benötigt, um einen dem Abstand der beiden Schlitze entsprechenden Weg zurückzulegen. Anhand der gemessenen Zeit sowie der Distanz kann anschliessend die Geschwindigkeit der Partikel errechnet werden. Im Gegensatz zu den übrigen, heutzutage noch überwiegend eingesetzten Verfahren und Einrichtungen braucht bei dieser Vorrichtung keine separate Lichtquelle zum Beleuchten der Partikel eingesetzt zu werden, da die Eigenstrahlung der erhitzten Partikel zur Bestimmung ihrer jeweiligen Position verwendet wird. Zur Bestimmung der Partikeltemperatur wird die sogenannte Zweifarben-Pyrometrie-Technik angewendet, bei der die vom Sensor empfangene Eigenstrahlung eines Partikels aufgeteilt und zwei separaten Photodetektoren zugeführt wird. Dabei ist jedem Photodetektor ein Interferenz-Filter unterschiedlicher Wellenlänge vorgeschaltet.

Obwohl dieses Verfahren und die darauf aufbauende Vorrichtung an und für sich aufschlussreiche Messresultate liefert, welche für die qualitative Beurteilung des Beschichtungsprozesses herangezogen werden können, ist ein solches Verfahren aufwendig und die entsprechende Vorrichtung teuer. Zudem birgt eine im wesentlichen nur punktuelle Messung die Gefahr, dass an einer nicht aussagekräftigen bzw. nicht repräsentativen Stelle des Strahl gemessen wird. Insbesondere kann durch eine im wesentlichen punktuelle Messung keine Aussage über die Verteilung der im Plasmastrahl bewegten Partikel gemacht werden; dies bedeutet, dass nicht erkennbar ist, ob die Partikel bezüglich der Querausdehnung des Plasmastrahls gleichmässig verteilt sind.

Ein weiteres Problem, das sich insbesondere beim Plasmaspritzen stellt, besteht darin, dass die für den Lichtbogen verantwortliche(n) Elektrode bzw. Elektroden abschmelzen und das abgeschmolzene Elektrodenmaterial, meistens Wolfram, mittels des Plasmastrahls auf das Substrat aufgetragen wird. Werden solche Wolframpartikel unerwünschterweise aufgetragen, muss die aufgetragene Schicht in der Regel entfernt und das Substrat neu beschichtet werden. Besonders kostenintensiv sind solche Korrekturen, wenn die Wolframeinschlüsse erst im Anschluss an die Nachbearbeitung entdeckt werden. Allenfalls könnten solche Wolframspritzer von einer Bedienungsperson als Funkenflug erkannt werden. Voraussetzung dafür ist jedoch, dass die Bedienungsperson den Beschichtungsprozess mit hoher Aufmerksamkeit verfolgt. Insbesondere bei grossen Serien, wie z.B. im Automobilbau, und/oder bei schwierigen Umgebungsbedingungen ist eine ständige und sorgfältige visuelle Beobachtung jedoch kaum möglich. Erschwerend kommt hinzu, dass die im Plasmastrahl bewegten Partikel sehr oft eine Geschwindigkeit von über 50 m/s aufweisen, was die Problematik einer visuellen Überwachung zusätzlich verdeutlicht. Zudem ist es mit einer im wesentlichen punktuellen Messung überhaupt nicht möglich, solchen Funkenflug systematisch zu erkennen.

Es ist daher die Aufgabe der Erfindung, eine Einrichtung zur Überwachung des Beschichtungsprozesses einer thermischen Beschichtungsvorrichtung nach dem Oberbegriff des Anspruchs 1 vorzuschlagen, mittels welcher der Beschichtungsstrahl bzw. die von den mitgeführten Partikeln emittierte, elektromagnetische Strahlung systematisch erfasst werden kann, wobei die Einrichtung einfach und kostengünstig realisierbar sein und in Bezug auf die zu überwachenden Beschichtungsparameter eine hohe Empfindlichkeit aufweisen soll und wobei zudem zuverlässige Angaben bezüglich der zu erwartenden Schichtqualität ermöglicht werden sollen.

Diese Aufgabe wird durch die im Kennzeichen des Anspruchs 1 aufgeführten Merkmale gelöst.

Mit einer Einrichtung, die eine Sensoranordnung mit einer Vielzahl von Sensoren aufweist und/oder mit optischen Mitteln versehen ist, welche die von den Partikeln emittierte Strahlung in einzelnen Bereichen eines Abschnitts, der quer zur Richtung des Beschichtungsstrahls verläuft, getrennt erfasst, ermöglicht es, den Plasmastrahl systematisch zu überwachen, indem dieser über seine gesamte Breite gemessen werden kann. Zudem kann durch eine messtechnische Aufteilung des Beschichtungsstrahls in einzelne Bereiche die Empfindlichkeit der Einrichtung erhöht werden.

Durch die der Sensoranordnung nachgeschalteten, elektronischen Mittel kann eine Auswertung der erfassten Signale erfolgen und eine Beurteilung bezüglich der zu erwartenden Schichtqualität vorgenommen werden.

Ein bevorzugtes Ausführungsbeispiel sieht vor, dass sie Sensoranordnung acht bis vierundsechzig Sensoren umfasst. Durch eine derartige Anzahl von Sensoren wird die Empfindlichkeit bezüglich der gemessenen Strahlung erhöht. Zudem werden Quervergleiche der an den Sensoren anliegenden Signale ermöglicht, was bezüglich der Auswertung der gemessenen Signale neue Möglichkeiten eröffnet.

Beispielsweise kann, wie in einem bevorzugten Ausführungsbeispiel umschrieben ist, die räumliche Intensitätsverteilung der von den erhitzten Partikeln emittierten, elektromagnetischen Strahlung ermittelt werden.

In diesem Zusammenhang hat sich überraschenderweise gezeigt, dass es zumeist gar nicht nötig ist, die Temperatur und die Geschwindigkeit der im Plasmastrahl erhitzen Partikel zu messen, sondern dass es in den allermeisten Fälle genügt, wenn als relevante Grösse zur qualitativen Beurteilung des Beschichtungsprozesses die räumliche Intensitätsverteilung der von den erhitzten Partikeln emittierten Strahlung herangezogen wird. Durch das Ermitteln der räumlichen Intensitätsverteilung der von den erhitzten Partikeln emittierten Strahlung kann eine Aussage bezüglich der für die Schichtqualität massgebenden Energieverteilung im Plasmastrahl gemacht werden, wobei im vorliegenden Fall die in einem einzelnen Partikel gespeicherte Energie im wesentlichen von dessen Temperatur und Grösse abhängt. Die in das einzelne Partikel eingebrachte, kinetische Energie wird in diesem Zusammenhang bewusst ausser Betracht gelassen.

Bei einem weiteren, bevorzugten Ausführungsbeispiel ist eine Grenzwertelektronik vorgesehen, mittels der am jeweiligen Sensor das Überschreiten eines vorgegebenen Signalwertes erkennbar ist. Durch eine solche Grenzwertelektronik wird das Erkennen von im Beschichtungsstrahl mitgeführten Partikeln ermöglicht, welche die durchschnittliche Grösse eines Beschichtungspartikels um ein Mehrfaches überschreiten. Mit dieser Grenzwertelektronik sollen insbesondere Metallpartikel, z.B. Wolfram, erkannt werden, die während des Betriebs der Beschichtungsvorrichtung von deren Elektrode abschmelzen und eine Beeinträchtigung der aufgetragenen Schicht darstellen.

Das gleiche trifft für die Differenzierschaltung zu, welche als Alternative zur Grenzwertelektronik vorgesehen sein kann.

Im Anspruch 17 wird ein Verfahren zur Überwachung des Beschichtungsprozesses thermischer Beschichtungsvorrichtung mit einer Einrichtung gemäss Anspruch 1 unter Schutz gestellt.

Anhand von Zeichnungen soll die Erfindung nachfolgend näher erläutert werden. In diesen Zeichnungen zeigt:
- Fig. 1: eine Prinzipskizze einer Beschichtungsvorrichtung zusammen mit der erfindungsgemässen Einrichtung;
- Fig. 1a: eine schematische Darstellung des von den Sensoren erfassten Ausschnitts des Plasmastrahls;
- Fig. 2: ein Blockschema der Einrichtung;
- Fig. 3: eine Prinzipdarstellung der Sensoren sowie eines projizierten Abschnitts des Beschichtungsstrahls; und
- Fig. 4: ein Diagramm, in das die zu einem bestimmten Zeitpunkt an den einzelnen Sensoren anstehenden Messwerte eingetragen sind.

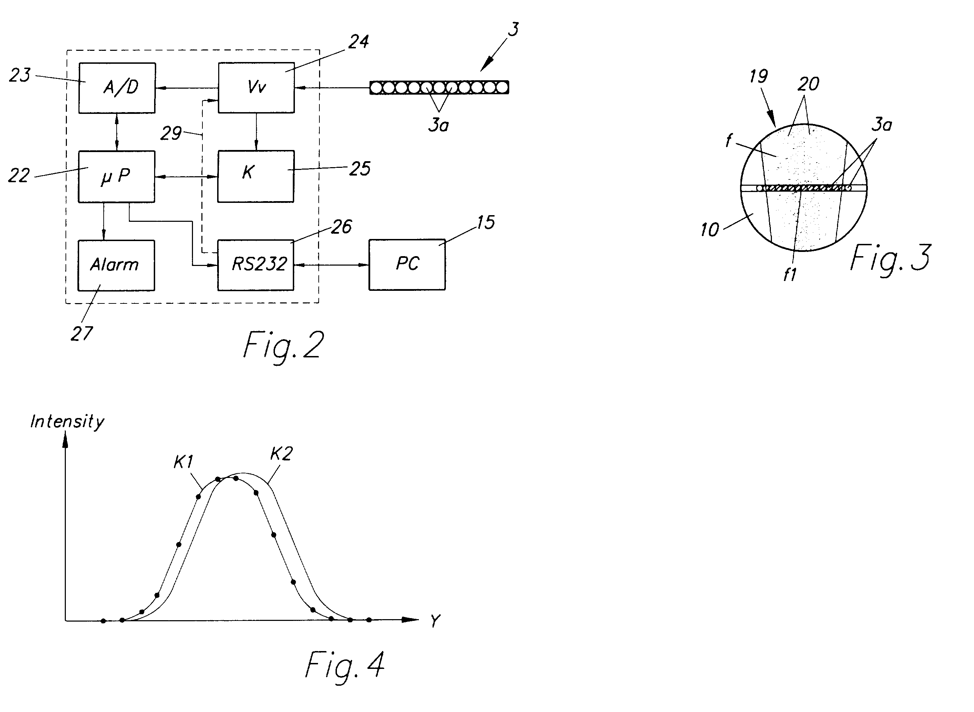

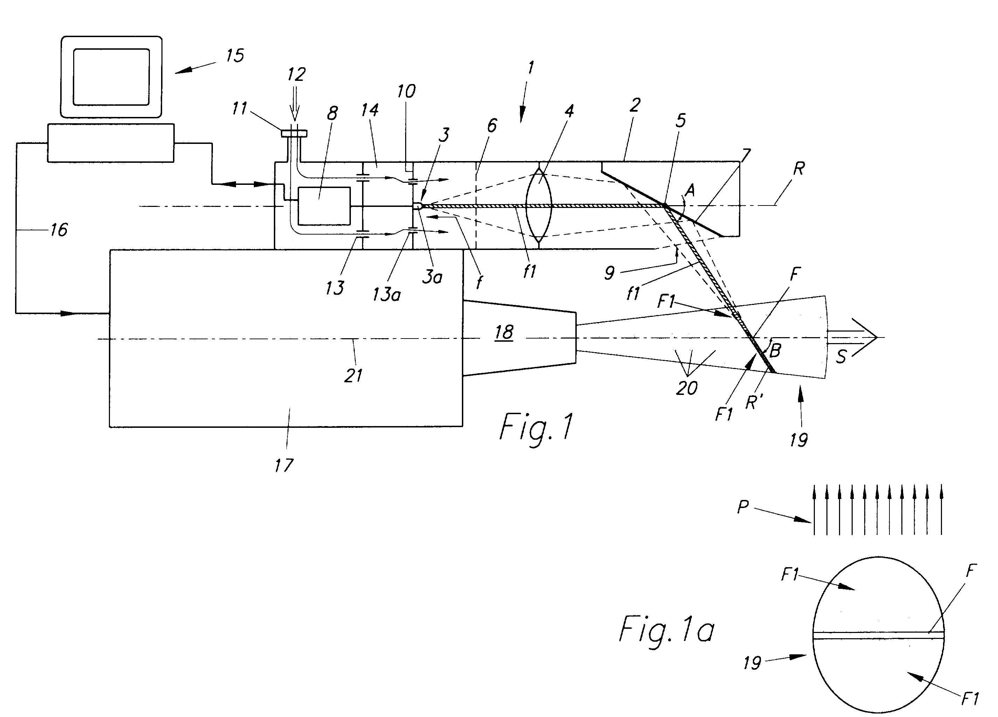

Fig. 1 zeigt in einer Prinzipskizze eine thermische Beschichtungsvorrichtung 17 zusammen mit einer Einrichtung 1 zur Überwachung des Beschichtungsprozesses. Als Beispiel für eine thermische Beschichtungsvorrichtung wird nachfolgend jeweils von einem Plasmaspritzgerät ausgegangen. Da der Aufbau und die Wirkungsweise von Plasmaspritzgeräten bekannt ist, braucht auf deren nähere Ausgestaltung nicht eingegangen zu werden. Beim vorliegenden Plasmaspritzgerät 17 ist der Brennerkopf mit 18 und der austretende Plasmastrahl mit 19 bezeichnet. Die im Plasmastrahl 19 mitgeführten und erhitzten Partikel sind mit dem Bezugszeichen 20 versehen.

Die in einem schematischen Längsschnitt dargestellte Einrichtung 1 zur Überwachung des Beschichtungsprozesses umfasst im wesentlichen ein Gehäuse 2, in dem eine Sensoranordnung 3, eine Optik in Form einer Linse 4, ein Filter 6 sowie ein Spiegel 7 aufgenommen sind. Die Weiterverarbeitung der von der Sensoranordnung 3 erfassten Signale erfolgt mittels elektronischen Komponenten, welche in Form eines Blockes 8 eingezeichnet sind. Zur Auswertung der Messdaten ist ein Rechner 15 vorgesehen. Auf der Unterseite ist das Gehäuse 2 mit einer Öffnung 9 versehen, hinter welcher der Spiegel 7 angeordnet ist. Das Gehäuse 2 ist, wie im vorliegenden Fall angedeutet, vorzugsweise direkt am Plasmaspritzgerät 17 befestigt.

Der Spiegel 7 dient der definierten Umlenkung derjenigen Strahlung, die von den erhitzten Partikeln 17 innerhalb eines sich quer über den Beschichtungsstrahl 19 erstreckenden Abschnitts F, F1 in Richtung der Pfeile P (Fig. 1a), d.h. in Richtung des Spiegels 7 emittiert wird. Die auf den Spiegel 7 fallende Strahlung des projizierten Abschnitts F1 wird auf die Linse 4 umgelenkt, von wo ein Projektionsfläche genanntes Abbild f des projizierten Abschnitts F1 über das Filter 6 auf eine Scheibe 10 projiziert wird. Im Zentrum dieser Projektionsfläche f bzw. der Scheibe 10 befindet sich die Sensoranordnung 3, welche eine Mehrzahl von lichtempfindlichen Sensoren 3a, beispielsweise zwanzig, aufweist, die, in Bezug auf die vorliegende Darstellung, horizontal in einer Reihe angeordnet sind. Durch diese Anordnung wird von jedem Sensor ein Querabschnitt F (Fig. 1a) des Plasmastrahls 19 erfasst, so dass dieser in seiner Querausdehnung messtechnisch in einzelne Bereiche aufgeteilt wird.

Die aus Spiegel 7, Linse 4, Filter 6 sowie Sensoranordnung 3 bestehenden, optischen Erfassungselemente sind derart aufeinander abgestimmt, dass die in einem quer zum Plasmastrahl ausgeschnittenen Abschnitt F, F1 des projizierten Abschnitts des Plasmastrahls 19 von den erhitzten Partikeln 17 in Richtung der Spiegelquerachse 5 emittierte Strahlung auf die Sensoren 3a gelenkt wird. Der auf die Sensoren 3a projizierte Abschnitt F, F1 verläuft unter einem Winkel B zur Strömungsrichtung S des Beschichtungsstrahls 17. Der Winkel B dürfte im Normalfall zwischen 20° und 90° betragen. Anzumerken ist, dass die auf die Sensoren 3a projizierte Strahlung der Summe derjenigen Strahlung entspricht, die von den im Abschnitt F, F1 befindlichen Partikeln 20 in Richtung der Spiegelquerachse 5 emittiert wird.

Der mit f1 bezeichnete Bereich soll den optischen Weg der auf die Sensoren projizierten Strahlung veranschaulichen, wobei zu berücksichtigen ist, dass der Bereich f1 in Wirklichkeit eine dreidimensionale Ausdehnung, d.h. eine weitere, unter einem rechten Winkel zur Zeichnungsebene verlaufende Ausdehnung besitzt. Aufgrund der an den einzelnen Sensoren 3a anliegenden Signale kann eine räumliche Intensitätsverteilung der von den erhitzten Partikeln 20 ausgehenden Strahlung im Strahlabschnitt F, F1 ermittelt werden. Die Intensität der von einem einzelnen Partikel ausgehenden Strahlung hängt im wesentlichen von der Temperatur und der Grösse des entsprechenden Partikels ab.

Bezüglich der von den Sensoren 3a erfassten Strahlung interessiert im vorliegenden Zusammenhang nur jeweils die Intensität, wobei unter Intensität die Beleuchtungsstärke in Lux (lm/m²) zu verstehen ist.

Um einen in Bezug auf den Brennerkopf 18 bzw. die Erfassungseinrichtung 1 entfernten Abschnitt des Plasmastrahls 19 erfassen zu können, ist der Spiegel 7 unter einem Winkel A von ca. 25° zur Längsmittelachse R der Einrichtung 1 bzw. zur Längsachse des Gehäuses 2 angeordnet. Dieser Winkel A kann den Anforderungen entsprechend gewählt werden und dürfte im Normalfall zwischen 10° und 45° betragen.

Anstelle eines abgewinkelten Spiegels 7 kann die Erfassungseinrichtung 1 natürlich auch derart ausgebildet werden, dass eine optische Achse R' der Einrichtung 1 mit der Längsachse 21 des Beschichtungsstrahls einen Winkel zwischen 10° und 90° einschliesst. Dies kann beispielsweise dadurch gelöst werden, dass das Gehäuse 2 in Bezug auf die Längsachse 21 des Beschichtungsstrahls 19 schräg bis quer angeordnet wird.

Das Filter 6 ist zur Abschwächung der Intensität und/oder zur Veränderung des Spektrums der auf die Sensoren 3a projizierten Strahlung f1 vorgesehen. Dabei ist es möglich, ein in Bezug auf das Durchgangsspektrum bzw. die Abschwächung der Strahlung variables Filter einzusetzen, welches vorzugsweise über den Rechner 15 ansteuerbar ist. Beispielsweise könnte ein Filter verwendet werden, dessen Eigenschaften sich durch das Anlegen einer elektrischen Spannung ändern. Auch das Hintereinanderschalten von mehreren Filtern ist durchaus denkbar. Der Sinn eines solchen Filters kann auch darin bestehen, Störstrahlungen, wie sie beispielsweise von einer Beleuchtung oder der Sonne ausgehen, auszufiltern oder eine Übersteuerung der Sensoren 3a zu verhindern. Die verwendeten Sensoren 3a sind vorzugsweise im infraroten und/oder sichtbaren Bereich empfindlich.

Zur Kühlung des Gehäuses 2 zusammen mit den darin angeordneten Bauelementen 3, 4, 6, 7, 8 ist das Gehäuse 2 mit einem Anschlussstutzen 11 versehen, über den Kühlluft 12 eingeleitet werden kann. Diese Kühlluft 12 wird über Durchlässe 13, 13a durch das Gehäuse 2 geleitet, um schliesslich endseitig über die Öffnung 9 auszutreten. Die Kühlluft bewirkt nebst einer Kühlung der Bauelemente 3, 4, 6, 7, 8, dass das Gehäuse 2 unter Überdruck steht und kein Schmutz über die Öffnung 9 in das Gehäuse 2 eindringen kann. Dies ist insofern wichtig, als die Erfassungseinrichtung 1 insbesondere beim Beschichten von Hohlraumwandungen starken Emissionen ausgesetzt ist.

Fig. 2 zeigt anhand eines stark vereinfachten Blockschemas 8 die der Sensoranordnung 3 nachgeschalteten, elektronischen Komponenten sowie deren Zusammenwirken. Nebst der Sensoranordnung 3 und dem z.B. als PC ausgebildeten Rechner 15 umfasst die Einrichtung im wesentlichen einen Mikroprozessor 22, einen A/D-Wandler mit Multiplexer 23, mehrere Vorverstärker 24, mehrere Komparatoren mit Spitzenwertspeichern 25, eine serielle Schnittstelle 26 sowie einen Alarmausgang 27, wobei pro Sensor 3a je ein Vorverstärker 24 sowie ein Komparator mit Spitzenwertspeicher 25 vorgesehen ist. Die Vorverstärker 24 sind vorzugsweise derart ausgebildet, dass sowohl deren Offsetspannung wie auch Verstärkungsfaktor über den Rechner 15 veränderbar sind, was durch eine unterbrochen dargestellte Linie 29 angedeutet ist.

Zum Ermitteln der räumlichen Intensitätsverteilung wird das am jeweiligen Sensor 3a anliegende Signal im Vorverstärker 24 verstärkt, über den Multiplexer dem A/D-Wandler 23 zugeführt und anschliessend vom Mikroprozessor 22 verarbeitet. Vom Mikroprozessor 22 werden die Daten über die serielle Schnittstelle 26 zum Rechner 15 übertragen, wo eine qualitative Beurteilung von für die Beschichtungsqualität massgebenden Parametern vorgenommen wird, indem beispielsweise die räumliche Intensitätsverteilung der von den erhitzten Partikeln emittierten, elektromagnetischen Strahlung ermittelt wird.

Zur Erfassung von im Beschichtungsstrahl mitgeführten Partikeln, welche die durchschnittliche Grösse eines Beschichtungspartikels um ein Mehrfaches überschreiten, ist der Ausgang des jeweiligen Vorverstärkers 24 zudem mit je einem Komparator 25 mit Spitzenwertspeicher verbunden. Als Vergleichswert wird am Eingang des jeweiligen Komparators 25 ein Signal angelegt, welches vom Mikroprozessor 22 errechnet wird und einem Mittelwert der am jeweiligen Sensor 3a während einer bestimmten Zeitspanne gemessenen Strahlungsintensität entspricht. Zum Anlegen dieser Spannung ist zwischen den Mikroprozessor 22 und den Komparator 25 ein D/A-Wandler geschaltet, der jedoch nicht eingezeichnet ist. Sobald der Istwert den Vergleichswert um einen bestimmten Betrag überschritten hat, wird vom Mikroprozessor 22 eine Meldung an die Alarmeinheit 27 ausgegeben. Das mit einer solchen Grenzwertschaltung zu erreichende Ziel besteht darin, allfällig im Beschichtungsstrahl mitgeführte Teile zu erkennen, welche nicht vom Beschichtungspulver selber stammen. Als Beispiel für solche Teile seien Wolframpartikel genannt, die von der im Brennerkopf für die Erzeugung des Lichtbogens massgebenden Elektrode abschmelzen. Derartige Wolframpartikel beeinträchtigen im allgemeinen die aufgetragene Schicht massgeblich.

Zur Erfassung solcher Wolframpartikel kann anstelle einer Grenzwertschaltung natürlich auch eine Differenzierschaltung vorgesehen werden. Der Vorteil einer Differenzierschaltung besteht darin, dass diese nur auf schnelle, relative Signaländerungen und nicht auf langsame, absolute Änderungen anspricht, was sie relativ unempfindlich in Bezug auf betriebsbedingte Schwankungen sowie externe Einflüsse macht. Allerdings muss für eine Differenzierung des Signals letzteres mit einer hohen Abtastrate erfasst und innerhalb der zur Verfügung stehenden Zeit jeweils eine Differenz gebildet werden, was gegenüber einer Grenzwertschaltung eine aufwendigere Elektronik mit sich bringt. Da solche Differenzierschaltungen jedoch bekannt sind, erübrigt es sich, an dieser Stelle näher darauf einzugehen.

Anstelle einer Vielzahl von Sensoren können auch optische Mittel vorgesehen werden, um die Strahlung in einem Abschnitt des Beschichtungsstrahls, in seiner Querausdehnung messtechnisch in einzelne Bereiche aufgeteilt, zu erfassen. Als derartiges Mittel kann beispielsweise ein beweglicher Spiegel angeführt werden, der es erlaubt, durch eine Schwenkbewegung den Beschichtungsstrahl in seiner gesamten Breite zu erfassen. Denkbar wäre beispielsweise auch eine Stufenlinse, deren einzelne Stufen je einen Querbereich des Beschichtungsstrahls auf der Sensoranordnung abbilden, wobei auch eine Kombination von mehreren Sensoren mit derartigen Mitteln denkbar wäre.

Fig. 3 zeigt in einer gegenüber der Fig. 1 vergrösserten Prinzipdarstellung die Sensoren 3a zusammen mit der auf die Scheibe 10 fallenden Projektionsfläche f des projizierten Abschnitts F, F1 des Beschichtungsstrahls 19. Die von den Sensoren 3a erfasste Fläche f1 ist dabei schraffiert eingezeichnet. Wie aus dieser Darstellung ersichtlich ist, überlappen die Sensoren 3a den Plasmastrahl 19 bevorzugt auf beiden Seiten, so dass auch bei einer Relativbewegung des Plasmastrahls 19 letzterer durch die Sensoren noch in seiner gesamten Breite erfasst wird. Aus dieser Darstellung ist zudem ersichtlich, dass die Partikeldichte im Zentrum des Plasmastrahls 19 am höchsten und im Randbereich am geringsten ist. Das bedeutet somit, dass bei einer gewünschten, gleichmässigen Verteilung der Partikel 20 im Plasmastrahl 19 die Strahlung im Zentrum am grössten ist, währenddem sie in den Randbereichen am kleinsten ist.

Fig. 4 zeigt ein Diagramm, in das die zu einem bestimmten Zeitpunkt an den einzelnen Sensoren anstehenden Messwerte eingetragen und durch eine Linie miteinander verbunden sind. Dabei ist die Istwert-Kurve mit K1 und die Sollwert-Kurve mit K2 bezeichnet. Aus der im Diagramm aufgetragenen Kurve K1 können folgende Angaben abgelesen und bestimmt werden:
- die räumliche Verteilung der von den erhitzten Partikeln emittierten Strahlung,
- die Intensität der erfassten Strahlung,
- die Querausdehnung der im Beschichtungsstrahl mitgeführten Beschichtungspartikel, und
- die Lage des Beschichtungsstrahls.

Aufgrund dieser Daten kann eine qualitative Beurteilung der zu erwartenden Schicht vorgenommen werden. Das Auftragen einer derartigen Kurve kann vollautomatisch durch den Rechner erfolgen.

Es versteht sich, dass die Einrichtung in Bezug auf eine koaxial zum Plasmastrahl verlaufende Kreisringfläche derart angeordnet wird, dass die zu erwartenden Veränderungen des Plasmastrahls bzw. der darin mitströmenden, erhitzten Partikel möglichst quer zur Erfassungsebene der Einrichtung erfolgen, wodurch Veränderungen bezüglich der Partikelverteilung für die Einrichtung erkennbar werden. Da die Partikel dem Plasmastrahl üblicherweise radial zugeführt werden, bedeutet dies, dass die Einrichtung unter einem rechten Winkel zu einer durch die Längsachse des Plasmastrahls und einer Pulver-Zuführdüse gelegten Ebene angeordnet werden sollte.

Anstelle einer visuellen Beurteilung und Auswertung der Kurve können die Messresultate natürlich auch rechnerisch ausgewertet werden. Beispielsweise kann die aufgetragene Istwert-Kurve K1 mit einer Sollwert-Kurve K2 verglichen werden. Dabei können bezüglich der erfassten Parameter Grenzwerte gesetzt werden, bei deren Überschreitung eine Warnung ausgegeben oder ein Alarm ausgelöst wird. Durchaus möglich ist jedoch auch, dass die gemessenen Werte als Istwerte in einen Regelkreis eingehen, mittels dem das Plasmaspritzgerät vollautomatisch gesteuert wird, bzw. direkten Einfluss auf die variierbaren Betriebsparameter, wie beispielsweise Stromstärke, Partikelmenge, Träger- und Plasmagasgeschwindigkeit bzw. Menge genommen wird. Die Möglichkeit eines Regelkreises ist durch die zwischen dem Rechner 15 und dem Plasmaspritzgerät 17 angeordnete Leitung 16 angedeutet (Fig. 1).

## Patentansprüche

1. Einrichtung (1) zur Überwachung des Beschichtungsprozesses einer thermischen Beschichtungsvorrichtung (17), welche eine Sensoranordnung (3) zur Messung der von im Beschichtungsstrahl (19) der Beschichtungsvorrichtung (17) mitgeführten Partikeln (20) ausgehenden, elektromagnetischen Strahlung sowie elektronische Mittel (8, 15) zur Auswertung von an der Sensoranordnung (3) anliegenden Signalen umfasst, **dadurch gekennzeichnet**, dass die Sensoranordnung (3) eine Vielzahl von Sensoren (3a) und/ oder optische Mittel zur getrennten Erfassung der von den Partikeln (20) in einzelnen Bereichen entlang eines quer zur Richtung des Beschichtungsstrahls (19) verlaufenden Abschnitts emittierten Strahlung aufweist.

2. Einrichtung nach Anspruch 1, dadurch gekennzeichnet, dass die Sensoranordnung (3) 8 bis 64 Sensoren (3a) umfasst.

3. Einrichtung nach Anspruch 2, dadurch gekennzeichnet, dass die Sensoren (3a) in einer Reihe nebeneinander angeordnet sind.

4. Einrichtung nach Anspruch 1, dadurch gekennzeichnet, dass die optischen Mittel Komponenten umfassen, welche den von der Sensoranordnung (3) bzw. den Sensoren (3a) räumlich erfassten Bereich verändern.

5. Einrichtung nach einem der vorhergehenden Ansprüche, dadurch gekennzeichnet, dass die elektronischen Mittel eine Auswertevorrichtung (15) umfassen, welche aufgrund des an der Sensoranordnung (3) bzw. an den einzelnen Sensoren (3a) anliegenden Signals die räumliche Intensitätsverteilung der von den erhitzten Partikeln (20) emittierten, elektromagnetischen Strahlung ermittelt.

6. Einrichtung nach einem der Ansprüche 2 bis 5, dadurch gekennzeichnet, dass der Sensoranordnung (3) ein Komparator (25) nachgeschaltet ist, mittels welchem das Überschreiten eines vorgegebenen Signalwertes erkennbar ist.

7. Einrichtung nach Anspruch 6, dadurch gekennzeichnet, dass der Komparator (25) mit einem Spitzenwertspeicher gekoppelt ist.

8. Einrichtung nach einem der Ansprüche 2 bis 5, dadurch gekennzeichnet, dass jedem Sensor (3a) ein Komparator (25) und ein Spitzenwertspeicher nachgeschaltet sind.

9. Einrichtung nach einem der Ansprüche 1 bis 5, dadurch gekennzeichnet, dass die elektronischen Mittel (8) eine Differenzierschaltung umfassen, mittels der ein an der Sensoranordnung (3) bzw. am jeweiligen Sensor (3a) innerhalb einer definierten Zeit erfolgender, einen bestimmten Wert überschreitender Signalanstieg erkennbar ist.

10. Einrichtung nach einem der Ansprüche 2 bis 9, dadurch gekennzeichnet, dass jedem Sensor (3a) ein Vorverstärker (24) nachgeschaltet ist.

11. Einrichtung nach einem der vorhergehenden Ansprüche, dadurch gekennzeichnet, dass die optischen Mittel weitere, der Sensoranordnung (3) vorgeschaltete Komponenten umfassen, welche die von den Partikeln (20) emittierte Strahlung in einem sich zumindest annähernd entlang des Durchmessers des Beschichtungsstrahls (19) erstreckenden Abschnitt (F1) erfassen und auf die Sensoranordnung (3) projizieren.

12. Einrichtung nach Anspruch 11, dadurch gekennzeichnet, dass der Sensoranordnung (3) ein Spiegel (7) vorgeschaltet ist, der die zu erfassende Strahlung auf die Sensoranordnung (3) umlenkt.

13. Einrichtung nach Anspruch 12, dadurch gekennzeichnet, dass der Spiegel (7) mit der Längsmittelachse (R) der Einrichtung (1) bzw. der Längsachse (21) des Beschichtungsstrahls (19) einen Winkel (A) zwischen 10° und 45° einschliesst.

14. Einrichtung nach Anspruch 11, dadurch gekennzeichnet, dass die der Sensoranordnung (3) vorgeschalteten Komponenten derart angeordnet sind, dass eine optische Achse (R') der Einrichtung (1) mit der Längsachse (21) des Beschichtungsstrahls (19) einen Winkel (B) 10° und 90° einschliesst.

15. Einrichtung nach einem der Ansprüche 11 bis 14, dadurch gekennzeichnet, dass der Sensoranordnung (3) ein Filter (6) vorgeschaltet ist, mittels welchem die Intensität und/oder das Spektrum der erfassten Strahlung veränderbar ist.

16. Einrichtung nach einem der Ansprüche 11 bis 15, dadurch gekennzeichnet, dass die Sensoranordnung (3) sowie die optischen und elektronischen Mittel (4, 6, 7, 8) in einem Gehäuse (2) untergebracht sind, welches unter pneumatischem Überdruck steht, wobei das Gehäuse (2) eine Öffnung (9) für das unter Überdruck stehende Gas aufweist.

17. Verfahren zur Überwachung des Beschichtungsprozesses einer thermischen Beschichtungsvorrichtung (17) mit einer Einrichtung gemäss Anspruch 1, **dadurch gekennzeichnet,** dass aufgrund der gemessenen Signale eine qualitative Beurteilung des Beschichtungsprozesses und/oder eine Beeinflussung desselben vorgenommen wird.

18. Verfahren nach Anspruch 17, dadurch gekennzeichnet, dass aufgrund der gemessenen Signale die räumliche Intensitätsverteilung der von den Partikeln (20) emittierten Strahlung ermittelt und als relevante Grösse zur qualitativen Beurteilung und/oder Beeinflussung des Beschichtungsprozesses herangezogen wird.

19. Verfahren nach Anspruch 17 oder 18, mit einer Einrichtung nach Anspruch 2, dadurch gekennzeichnet, dass das am jeweiligen Sensor (3a) anliegende Signal mit einem Sollwert verglichen und bei Überschreitung einer vorbestimmten Abweichung eine Meldung ausgegeben oder ein Alarm ausgelöst wird.

20. Verfahren nach Anspruch 19, dadurch gekennzeichnet, dass als Sollwert der Mittelwert des über einen bestimmten Zeitraum am jeweiligen Sensor anstehenden Signals herangezogen wird.

21. Verfahren nach Anspruch 17 oder 18, dadurch gekennzeichnet, dass die gemessenen Signale mit Sollwerten verglichen werden und bei Überschreitung einer vorbestimmten Abweichung direkt Einfluss auf einen oder mehrere Betriebsparameter der Beschichtungsvorrichtung (17) genommen wird.

22. Verfahren nach Anspruch 21, dadurch gekennzeichnet, dass die gemessenen Werte als Istwerte für einen Regelkreis zur Steuerung der Beschichtungsvorrichtung (17) verwendet werden.

23. Verfahren nach Anspruch 17 oder 18, dadurch gekennzeichnet, dass das an den einzelnen Sensoren (3a) anliegende Signal differenziert wird, indem die an einem oder mehreren Sensor(en) (3a) innerhalb einer definierten Zeitspanne auftretende Signaländerung ermittelt und bei Überschreitung eines vorgegebenen Wertes eine Meldung ausgegeben und/oder eine Beeinflussung des Beschichtungsprozesses vorgenommen wird.

24. Verfahren nach Anspruch 23, dadurch gekennzeichnet, dass die Differenzierung des Signals zur Feststellung von im Beschichtungsstrahl (19) allfällig mitgeführten, von der/den für die Erzeugung eines Lichtbogens zuständigen Elektrode(n) abgeschmolzenen Metallpartikeln verwendet wird.

25. Verfahren nach Anspruch 23 oder 24, dadurch gekennzeichnet, dass das an der Sensoranordnung (3) bzw. an einem einzelnen Sensor (3a) anliegende Signal mit einer Abtastrate erfasst wird, welche, in kHz ausgedrückt, höher ist als die Geschwindigkeit des Plasmastrahls in m/s.

26. Verfahren nach Anspruch 25, dadurch gekennzeichnet, dass die Abtastrate höher als 50 kHz gewählt wird.

27. Verfahren nach einem der Ansprüche 17 bis 26, dadurch gekennzeichnet, dass die von den erhitzten Partikeln (20) emittierte Strahlung im infraroten und/oder sichtbaren Bereich erfasst wird.

28. Verfahren nach einem der Ansprüche 17 bis 27, dadurch gekennzeichnet, dass die von den erhitzten Partikeln (20) emittierte Strahlung optisch aufbereitet und auf die Sensoranordnung (3) bzw. die Sensoren (3a) projiziert wird.

29. Verfahren nach Anspruch 28, dadurch gekennzeichnet, dass die von den erhitzten Partikeln (20) emittierte Strahlung über zumindest einen Spiegel (7) und/oder eine Linse (4) auf die Sensoranordnung (3) bzw. die Sensoren (3a) gelenkt wird.

30. Verfahren nach Anspruch 28 oder 29, dadurch gekennzeichnet, dass die von den erhitzten Partikeln (20) emittierte Strahlung vor der Erfassung gefiltert wird.

31. Verfahren nach Anspruch 30, dadurch gekennzeichnet, dass ein in Bezug auf die Intensität und/oder das Spektrum der von der Sensoranordnung (3) bzw. den Sensoren (3a) empfangenen Strahlung variables Filter (6) verwendet wird.

32. Verfahren nach einem der Ansprüche 17 bis 31, dadurch gekennzeichnet, dass die lichtempfindliche Sensoranordnung (3) bzw. die Sensoren (3a) und/oder der allenfalls vorhandene Spiegel (7) und/oder die Linse (4) und/oder das Filter (6) mittels Luft gekühlt werden.

33. Verfahren nach einem der Ansprüche 17 bis 31, dadurch gekennzeichnet, dass die von der lichtempfindlichen Sensoranordnung (3) bzw. den Sensoren (3a) erfassten Signale digitalisiert und danach digital zu einer Auswerteeinheit (14) übertragen werden.
